**Europäisches Patentamt**

**European Patent Office**

**Office européen des brevets**

(19)

(11) Veröffentlichungsnummer: **0 090 147**
**B1**

(12) EUROPÄISCHE PATENTSCHRIFT

(45) Veröffentlichungstag der Patentschrift:
**16.10.85**

(51) Int. Cl.⁴: **G 01 R 31/34**

(21) Anmeldenummer: **83100944.4**

(22) Anmeldetag: **01.02.83**

(54) Schaltungsanordnung zur Überwachung des Abnutzungsgrads von Kommutator-Kohlebürsten.

(30) Priorität: **26.03.82 DE 3211251**

(43) Veröffentlichungstag der Anmeldung:
**05.10.83 Patentblatt 83/40**

(45) Bekanntmachung des Hinweises auf die Patenterteilung:
**16.10.85 Patentblatt 85/42**

(84) Benannte Vertragsstaaten:
**AT CH FR GB IT LI NL**

(56) Entgegenhaltungen:
**DE - A - 1 804 290**
**DE - A - 2 605 114**

(73) Patentinhaber: **Steinbock GmbH,
Steinbockstrasse 38-40, D-8052 Moosburg/Isar (DE)**

(72) Erfinder: **Kollmannsberger, Otto, Kleiberstrasse 8,
D-8052 Moosburg (DE)**
Erfinder: **Schmid, Martin, Aiter Pfarrhof 22,
D-8301 Niederhornbach (DE)**

(74) Vertreter: **Weickmann, Heinrich, Dipl.-Ing. et al,
Patentanwälte Dipl.-Ing. H.Weickmann Dipl.-Phys.Dr.
K.Fincke Dipl.-Ing. F.A.Weickmann Dipl.-Chem. B. Huber
Dr.-Ing. H. Liska Dipl.-Phys.Dr. J. Prechtel
Postfach 860820, D-8000 München 86 (DE)**

## Beschreibung

Die Erfindung betrifft eine Schaltungsanordnung zur Überwachung des Abnutzungsgrads von Kommutator-Kohlebürsten eines Gleichstrom-Elektromotors in einem akkumulatorbetriebenen Elektrofahrzeug, insbesondere einem Gabelstapler, bei welcher die Kommutator-Kohlebürsten elektrisch isolierte Kontrollbürsten eines optischen und/oder akustischen Warnsignalgebers tragen, die ab einem vorgegebenen Abnutzungsgrad der Kommutator-Kohlebürsten auf den Kommutator aufsetzen und hierdurch den Warnsignalgeber einschalten.

Bei bekannten Schaltungsanordnungen dieser Art besteht der Warnsignalgeber im wesentlichen aus einer Signalleuchte, die zwischen die Kontrollbürsten und einen Pol des Akkumulators des Elektrofahrzeugs angeschlossen ist. Bei abgenutzten Kommutator-Kohlebürsten schliessen die Kontrollbürsten den Stromkreis der Signalleuchte über den Anker des Elektromotors zum anderen Akkumulatorpol. Da sich bei schwankender Betriebsbelastung des Motors das Kommutator-Potential ändert, schwankt die Leuchtkraft der herkömmlich benutzten Signalleuchte. Eine Schaltungsanordnung dieser Art mit einer Hilfsspannungsquelle in der Überwachungsanordnung ist in der DE-A Nr. 1804290 beschrieben.

Aufgabe der Erfindung ist es, die bekannte Schaltungsanordnung zur Überwachung des Abnutzungsgrads von Kommutator-Kohlebürsten so zu verbessern, dass während des Betriebs des Elektrofahrzeugs eine gleichmässige und kontinuierliche Anzeige eines unzulässig hohen Abnutzungsgrads auch bei lediglich kurzzeitiger Berührung des Kommutators durch die Kontrollbürsten erfolgt.

Diese Aufgabe wird erfindungsgemäss dadurch gelöst, dass die Kontrollbürsten an eine den Warnsignalgeber steuernde, elektrische Speicherstufe angeschlossen sind und die Speicherstufe bei Kontaktierung des Kommutators setzen, dass die gesetzte Speicherstufe den Warnsignalgeber unabhängig vom Aufsetzzustand der Kontrollbürsten einschaltet und dass ein bei Inbetriebnahme des Elektrofahrzeugs durch Einschalten seines Hauptschalters ansprechender Rücksetzkreis die Speicherstufe rücksetzt.

Die Speicherstufe wird von dem Rücksetzkreis nach Inbetriebnahme des Elektrofahrzeugs rückgesetzt oder gelöscht, womit der Warnsignalgeber abgeschaltet ist. Berühren im nachfolgenden Betrieb des Elektrofahrzeugs die Kontrollbürsten den Kommutator des Elektromotors, so wird die Speicherstufe gesetzt und der Warnsignalgeber eingeschaltet. Hierzu genügt es, wenn die Kontrollbürsten den Kommutator nur kurzzeitig berühren, was insbesondere bei Annäherung an die Abnutzungsgrenze der Fall sein kann. Die Speicherstufe sorgt für kontinuierliche und gleichmässige Steuerbedingungen für den Warnsignalgeber.

In einer bevorzugten Ausführungsform ist der Warnsignalgeber an ein bei Inbetriebnahme des Elektrofahrzeugs durch Einschalten seines Hauptschalters auslösbares Zeitglied angeschlossen, welches den Warnsignalgeber für eine vorbestimmte Zeitspanne unabhängig vom Aufsetzzustand der Kontrollbürsten einschaltet. Mittels des Zeitglieds lässt sich die ordnungsgemässe Funktion des Warnsignalgebers, insbesondere dessen Signalleuchte oder dergl., überprüfen. Bei ordnungsgemässer Funktion muss die Signalleuchte bei Inbetriebnahme des Fahrzeugs für die vorbestimmte Zeitspanne, beispielsweise 1 bis 2 Sekunden, aufleuchten und dann erlöschen. Zweckmässigerweise wird die Speicherstufe mittels des Zeitglieds zurückgesetzt.

Im folgenden soll ein Ausführungsbeispiel der Erfindung anhand einer Zeichnung näher erläutert werden. Diese zeigt ein Blockschaltbild einer Kohlebürsten-Überwachungsschaltung.

An einen Akkumulator 1 eines Elektrofahrzeugs, insbesondere eines Gabelstaplers, ist über einen Schütz 3 der Ankerstromkreis 5 eines Gleichstrom-Elektromotors, beispielsweise des Fahrmotors, angeschlossen. Nicht dargestellt sind etwa vorhandene Polwendeschaltungen zur Drehrichtungsumkehr und der ebenfalls über Schütze an den Akkumulator angeschlossene Ständerstromkreis des Motors. Gleichfalls nicht dargestellt sind Steuerschaltungen zur Leistungssteuerung des Motors. Sämtliche Stromkreise des Elektrofahrzeugs werden von einem Hauptschalter 7, beispielsweise einem Schlüsselschalter oder dergl., eingeschaltet. Der Hauptschalter 7 ist während des Betriebs des Fahrzeugs geschlossen. Er steuert insbesondere auch die Stromversorgung eines Steuerkreises 9, über die der Erregerstrom des Schützes 3 bzw. der Steuerstrom etwaiger elektronischer Schalter, die an Stelle des Schützes 3 vorgesehen sind, gesteuert wird.

Der Ankerstromkreis 5 umfasst herkömmlich einen Kommutator 11, an dem Kohlebürsten 13 schleifen. Jede der Kohlebürsten 13 trägt mit radialem Abstand vom Kommutator 11 eine Kontrollbürste 15, die gegenüber der Kommutator-Kohlebürste 13 isoliert ist. Ist ein vorbestimmter Abnutzungsgrad der Kommutator-Kohlebürsten 13 erreicht, so setzen die Kontrollbürsten 15 ebenfalls auf den Kommutator 11 auf. Die Kontrollbürsten 15 sind über Entkopplungswiderstände 17 oder Entkopplungsdioden oder dgl. an den Setzeingang einer Speicherstufe 19 angeschlossen, die auf die Spannungsänderung der Kontrollbürsten 15 anspricht. Die Speicherstufe 19 steuert über ein ODER-Gatter 21 eine Treiberstufe 23 einer Signalleuchte 25. Die Signalleuchte 25 wird eingeschaltet, wenn eine der Kontrollbürsten 15 den Kommutator 11 kurzzeitig oder dauernd berührt. Die Treiberstufe 23 sorgt für gleichbleibende Betriebsbedingungen der Signalleuchte 25 und kann ggf. als Blinkgeber ausgebildet sein. Bei der Speicherstufe 19 kann es sich um ein Flip-Flop oder einen elektronischen Schalter handeln, der durch Steuerimpulse ein- bzw. ausgeschaltet wird.

Bei geöffnetem Hauptschalter 7 ist die Stromversorgung der Speicherstufe 19, des ODER-Gatters 21 und der Treiberstufe 23 abgeschaltet.

Bei Inbetriebnahme des Fahrzeugs durch Schliessen des Hauptschalters 7 wird ein Zeitglied 27 gesetzt, welches die Speicherstufe 19 nach Ablauf seiner Zeitkonstanten rücksetzt und so für gleichbleibende Anfangsbedingungen sorgt. Das Zeitglied 27 ist über das ODER-Gatter 21 ebenfalls an die Treiberstufe 23 der Signalleuchte 25 angeschlossen und schaltet die Signalleuchte 25 für die Dauer seiner Zeitkonstanten ein. Bei Inbetriebnahme des Fahrzeugs kann so die ordnungsgemässe Funktion der Treiberstufe 23 und der Signalleuchte 25 überwacht werden.

Sofern das Elektrofahrzeug mehrere Elektromotoren umfasst, beispielsweise Lenkhilfemotore oder Pumpen-Antriebsmotore für hydraulische Anlagen, können deren Kommutator-Kohlebürsten in entsprechender Weise überwacht werden. Das Zeitglied 27 kann hierbei zur Kontrolle sämtlicher Warnsignalleuchten und zum Rücksetzen sämtlicher Speicherstufen ausgenutzt werden.

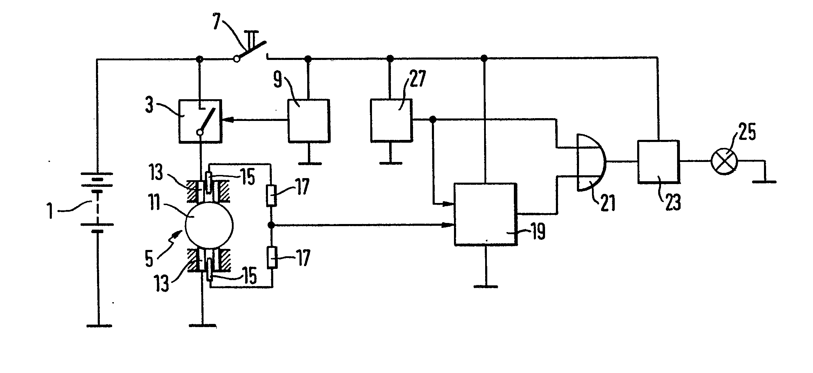

## Patentansprüche

1. Schaltungsanordnung zur Überwachung des Abnutzungsgrads von Kommutator-Kohlebürsten (13) eines Gleichstrom-Elektromotors in einem akkumulatorbetriebenen Elektrofahrzeug, insbesondere einem Gabelstapler, bei welcher die Kommutator-Kohlebürsten (13) elektrisch isolierte Kontrollbürsten (15) eines optischen und/oder akustischen Warnsignalgebers (23, 25) tragen, die ab einem vorgegebenen Abnutzungsgrad der Kommutator-Kohlebürsten (13) auf den Kommutator (11) aufsetzen und hierdurch den Warnsignalgeber (23, 25) einschalten, dadurch gekennzeichnet, dass die Kontrollbürsten (15) an eine den Warnsignalgeber steuernde, elektrische Speicherstufe (19) angeschlossen sind und die Speicherstufe (19) bei Kontaktierung des Kommutators (11) setzen, dass die gesetzte Speicherstufe (19) den Warnsignalgeber (23, 25) unabhängig vom Aufsetzzustand der Kontrollbürsten (15) einschaltet und dass ein bei Inbetriebnahme des Elektrofahrzeugs durch Einschalten seines Hauptschalters (7) ansprechender Rücksetzkreis die Speicherstufe (19) rücksetzt.

2. Schaltungsanordnung nach Anspruch 1, dadurch gekennzeichnet, dass der Warnsignalgeber (23, 25) an ein bei Inbetriebnahme des Elektrofahrzeugs durch Einschalten seines Hauptschalters (7) auslösbares Zeitglied (27) angeschlossen ist, welches den Warnsignalgeber (23, 25) für eine vorbestimmte Zeitspanne unabhängig vom Aufsetzzustand der Kontrollbürsten (15) einschaltet.

3. Schaltungsanordnung nach Anspruch 2, dadurch gekennzeichnet, dass das Zeitglied (27) die Speicherstufe (19) rücksetzt.

## Claims

1. Circuit arrangement for monitoring the degree of wear of commutator carbon brushes (13) of a direct-current electric motor in a battery-operated electric vehicle, especially a fork-lift truck, in which the commutator carbon brushes (13) carry electrically insulated monitor brushes (15) of an optical and/or acoustic warning signal emitter (23, 25) which, as from a pre-determined degree of wear of the commutator carbon brushes (13), apply themselves to the commutator (11) and thus switch on the warning signal emitter (23, 25), characterized in that the monitor brushes (15) are connected to an electric storage stage (19) which controls the warning signal emitter and set the storage stage (19) on contacting of the commutator (11), in that the set storage stage (19) switches on the warning signal emitter (23, 25) independently of the state of application of the monitor brushes (15) and in that a resetting circuit, which responds on setting of the electric vehicle in operation by switching on of its main switch (7), resets the storage stage (19).

2. Circuit arrangement according to Claim 1, characterized in that the warning signal emitter (23, 25) is connected to a time member (27) triggerable on setting of the electric vehicle in operation by switching on of its main switch (7), which time member switches on the warning signal emitter (23, 25) for a pre-determined period of time independently of the state of application of the monitor brushes (15).

3. Circuit arrangement according to Claim 2, characterized in that the time member (27) resets the storage stage (19).

## Revendications

1. Dispositif pour contrôler le taux d'usure de balais en charbon (13) du collecteur d'un moteur électrique à courant continu dans un véhicule électrique à accumulateur, en particulier un élévateur à fourche, dans lequel les balais en charbon (13) du collecteur portent des balais de contrôle (15), isolés électriquement, d'un générateur (23, 25) de signaux d'alarme optiques et/ou acoustiques, qui, à partir d'un degré d'usure prédéterminé des balais en charbon (13) du collecteur, s'appliquent contre ce collecteur (11) et enclenchent ainsi le générateur (23, 25) de signaux d'alarme, caractérisé par le fait que les balais de contrôle (15) sont raccordés à un étage électrique de mémorisation (19) commandant le générateur de signaux d'alarme, et amorcent cet étage de mémorisation (19) lors de la venue au contact du collecteur (11); par le fait que l'étage de mémorisation (19) amorcé enclenche le générateur (23, 25) de signaux d'alarme indépendamment de la condition dans laquelle les balais de contrôle (15) sont appliqués; et par le fait qu'un circuit de remise à zéro, réagissant lors de l'entrée en fonction du véhicule électrique par un enclenchement de son interrupteur principal (7), ramène l'étage de mémorisation (19) à zéro.

2. Dispositif selon la revendication 1, caractérisé par le fait que le générateur (23, 25) de signaux d'alarme est raccordé à un organe de temporisation (27) qui peut être enclenché lors de l'entrée en service du véhicule électrique par un enclenchement de son interrupteurrr principal (7), et qui enclenche le générateur (23, 25) de signaux d'alarme pour une période prédéterminée, indépendamment de la condition d'application des balais de contrôle (15).

3. Dispositif selon la revendication 2, caractérisé par le fait que l'organe de temporisation (27) remet l'étage de mémorisation (19) à zéro.